# EUROPÄISCHE PATENTANMELDUNG

(11) **EP 4 152 524 A1**
(43) Veröffentlichungstag der Anmeldung: **22.03.2023**
(21) Anmeldenummer: 22175353.6
(22) Anmeldetag: 25.05.2022
(51) Int. Cl.: H01R 12/53, H01R 43/02, H01R 9/05, H01R 4/02

(54) **LÖTHILFE, BAUGRUPPE SOWIE VERFAHREN ZUM FIXIEREN EINER LITZE AUF EINER KONTAKTFLÄCHE EINER LEITERPLATTE**

(30) Priorität: 15.09.2021 DE 102021123830
(71) Anmelder: MD Elektronik GmbH, 84478 Waldkraiburg (DE)
(72) Erfinder: Mannhold, Dimitri, 84453 Mühldorf am Inn (DE)

(57) **Zusammenfassung**

Die Erfindung betrifft eine Löthilfe zum Fixieren einer Litze eines Kabels auf einer elektrischen Kontaktfläche (1) einer Leiterplatte (2), umfassend ein Außenteil (5) mit einer Auflagefläche sowie ein Innenteil (6), wobei das Innenteil (6) innerhalb einer Aufnahme (7) des Außenteils (5) verschiebbar aufgenommen ist, wobei das Innenteil (6) einen Zugang (8) zu der Kontaktfläche (1) aufweist und in einer Montagestellung an dem Außenteil (5) befestigbar ist, und wobei in einer Einführstellung eine Einführöffnung (9) des Innenteils (6) mit einer Einführöffnung (10) des Außenteils (5) zur Einführung der Litze des Kabels ausgerichtet ist. Die genannte Löthilfe löst erfindungsgemäß die Aufgabe, eine Löthilfe bzw. ein Verfahren zum Fixieren einer Litze auf einer Kontaktfläche einer Leiterplatte anzugeben, so dass eine Vielzahl von Litzen mit geringem Durchmesser automatisiert bearbeitet werden können. Die Erfindung betrifft weiter eine Baugruppe, umfassend eine Leiterplatte (2) und eine Litze eines Kabels, wobei die Litze mittels einer Löthilfe auf einer Kontaktfläche (1) der Leiterplatte (2) befestigt ist. Die Erfindung betrifft ebenfalls ein Verfahren zum Fixieren einer Litze eines Kabels auf einer elektrischen Kontaktfläche einer Leiterplatte.

## Beschreibung

### Technisches Gebiet

Die Erfindung betrifft eine Löthilfe zum Fixieren einer Litze eines Kabels auf einer elektrischen Kontaktfläche einer Leiterplatte, eine Baugruppe sowie ein Verfahren zum Fixieren einer Litze eines Kabels auf einer elektrischen Kontaktfläche einer Leiterplatte.

### Stand der Technik

Bei der Verarbeitung von Kabeln tritt häufig der Fall auf, dass eine Litze des Kabels, insbesondere der Innenleiter eines als Koaxialkabel ausgebildeten Datenkabels, an einer Kontaktfläche einer Leiterplatte (Platine, auch PCB für ,printed circuit board') mechanisch und elektrisch leitend befestigt werden muss. Das Befestigen der Litze des Kabels wird häufig durch ein Löten ausgeführt, wobei ein Lotmaterial auf die Litze bzw. die Kontaktfläche aufgebracht wird, worauf das Lot unter Wärmezufuhr zum Schmelzen gebracht wird, um danach zu erstarren und die Litze mit dem Material der Kontaktfläche zu verbinden.

Für das Löten ist es erforderlich, in einem vorbereitenden Schritt die Litze auf die Kontaktfläche zu platzieren und für die Dauer der Verflüssigung des Lots an der definierten Stelle der Kontaktfläche fixiert zu halten.

Für das Fixieren der Litze eines endseitig abgemantelten Kabels auf der Kontaktfläche einer Leiterplatte sind aus der Praxis Löthilfen bekannt. Als Löthilfe kann ein Bauteil bezeichnet werden, in oder an das die Litze eingeführt wird, so dass die Litze, die beispielsweise als freigelegter Innenleiter eines Koaxialkabels ausgebildet sein kann, in der Löthilfe angeordnet und aufgenommen ist. Die Löthilfe wird auf der Leiterplatte befestigt, so dass die eingeführte Litze mindestens für die Dauer des Lötens auf der Kontaktfläche der Leiterplatte in einer definierten, möglichst reproduzierbaren Stellung gehalten wird.

Bei der automatisierten Fertigung tritt häufig die Forderung auf, Litzen von möglichst geringen Durchmesser in hoher Stückzahl in kurzer Zeit auf der Kontaktfläche einer Leiterplatte aufzubringen und mittels Löten zu befestigen; insbesondere sollen in möglichst einem Arbeitsschritt mehrere, parallel zueinander ausgerichtete Litzen auf parallel zueinander ausgerichteten Kontaktflächen einer Leiterplatte platziert und nachfolgend mit der Kontaktfläche verlötet werden.

EP 2 690 712 A2 beschreibt eine Löthilfe, die als flach ausgebildeter, einstückiger Zuschnitt mit einem Loch ausgebildet ist, wobei die Löthilfe im Wesentlichen senkrecht zu der Ebene der Leiterplatte an deren Rand fixiert wird, und wobei ein abgemantelter Endabschnitt eines Koaxialkabels an der Umrandung des Lochs so anliegt, dass die Litze des Koaxialkabels durch das Loch hindurch auf eine Kontaktfläche ausgerichtet und dort verlötet werden kann. Der Zuschnitt durchsetzt dabei Bohrungen in der Leiterplatte, in denen er mittels Fixiermitteln befestigt werden muss.

WO 2016/104586 A1 stellt mit Bezug auf Fig. 16 eine Löthilfe dar, die als einstückiges Formteil ausgebildet ist, wobei die Löthilfe in einem Schlitz in der Leiterplatte eingeklemmt ist, und wobei die Löthilfe eine Einführöffnung aufweist, durch die der endseitig abgemantelte Abschnitt eines Koaxialkabels auf der einen Seite so eingeführt wird, dass die Litze auf der anderen Seite auf die Kontaktfläche positioniert wird, um nachfolgend verlötet zu werden. Die Löthilfe weist auf der Oberseite eine Einbuchtung auf, durch die hindurch ein Schirmgeflecht des Koaxialkabels zugreifbar wird.

WO 02/084808 A1 beschreibt eine Vorrichtung zum Positionieren eines Koaxialkabels an einem Leiterstreifen einer Leiterplatte, wobei die Vorrichtung ein einstückiges Formteil aufweist, das in einem Schlitz in der Leiterplatte an der Oberseite sowie an der Unterseite der Leiterplatte befestigt wird, wobei das Formteil an einer Einführöffnung ein abgemanteltes Ende des Koaxialkabels aufnimmt, das an einem Ausgang der Einführöffnung noch von dem Isolator des Koaxialkabels umgeben ist. Die Vorrichtung ist unter einem Winkel zu der Ebene der Leiterplatte angeordnet, so dass die Litze des Koaxialkabels unter diesem Winkel auf den Leiterstreifen gedrückt positioniert wird, um nachfolgend verlötet zu werden.

US 5,532,659 A beschreibt ein im Wesentlichen U-förmiges Teil als Löthilfe, wobei an dem Boden des U ein abgemantelter Endabschnitt eines Koaxialkabels aufgenommen ist, und wobei zwischen den Schenkeln des U der freigelegte Innenleiter des Koaxialkabels auf einem Leiterstreifen einer mehrlagigen Leiterplatte aufliegt. Eine Kappe dient zur elektromagnetischen Abschirmung der ansonsten freiliegenden Anbindung der Litze bzw. des Innenleiters des Kabels an den Leiterstreifen.

### Beschreibung der Erfindung

Es ist eine Aufgabe der Erfindung, eine Löthilfe bzw. ein Verfahren zum Fixieren einer Litze auf einer Kontaktfläche einer Leiterplatte anzugeben, so dass eine Vielzahl von Litzen mit geringem Durchmesser automatisiert bearbeitet werden können.

Diese Aufgabe wird erfindungsgemäß gelöst durch eine Löthilfe zum Fixieren einer Litze eines Kabels auf einer elektrischen Kontaktfläche einer Leiterplatte, umfassend ein Außenteil mit einer Auflagefläche sowie ein Innenteil, wobei das Innenteil innerhalb einer Aufnahme des Außenteils verschiebbar aufgenommen ist, wobei das Innenteil einen Zugang zu der Kontaktfläche aufweist und in einer Montagestellung an dem Außenteil befestigbar ist, und wobei in einer Einführstellung eine Einführöffnung des Innenteils mit einer Einführöffnung des Außenteils zur Einführung der Litze des Kabels ausgerichtet ist.

Diese Aufgabe wird erfindungsgemäß weiter gelöst durch ein bevorzugt unter Verwendung der erfindungsgemäßen Löthilfe durchführbares Verfahren zum Fixieren einer Litze eines Kabels auf einer elektrischen Kontaktfläche einer Leiterplatte, mit den Schritten
- Bereitstellen einer Löthilfe mit einem Außenteil und einem innerhalb einer Aufnahme des Außenteils verschiebbar aufgenommenen Innenteil,
- Einführen der Litze des Kabels in einer Einführstellung, bei der eine Einführöffnung des Innenteils mit einer Einführöffnung des Außenteils zur Einführung der Litze des Kabels ausgerichtet ist, und
- Verbringen des Innenteils innerhalb der Aufnahme des Außenteils in eine Montagestellung, in der das Innenteil an dem Außenteil befestigt ist, wobei in der Montagestellung ein Zugang des Innenteils die elektrische Kontaktfläche der Leiterplatte zugänglich lässt, und wobei in der Montagestellung das Außenteil an der Leiterplatte befestigt wird, um die Litze auf der Kontaktfläche zu fixieren.

Die Löthilfe ist zweiteilig ausgebildet und umfasst das Außenteil sowie das Innenteil, das innerhalb der Aufnahme des Außenteils in Bezug auf das Außenteil verschiebbar aufgenommen ist. Das Innenteil und das Außenteil können baulich voneinander getrennt hergestellt werden. Durch die Verschiebung des Innenteils in dem Außenteil wird eine Montageposition erreicht, in der die Litze auf der Kontaktfläche so weit fixiert ist, dass in einem nachfolgenden Schritt Lotmaterial durch Wärmezufuhr die Litze auf der Kontaktfläche mechanisch und elektrisch leitend anbindet. Das Innenteil weist hierzu den Zugang zu der Kontaktfläche auf der Leiterplatte auf, durch den hindurch das Lot bzw. die Wärme, beispielsweise als Heizfinger oder als Laserstrahl, zum Schmelzen des Lots zu der auf der Kontaktfläche aufliegenden Litze zugeführt werden kann. In der Montagestellung ist das Innenteil an dem Außenteil befestigt.

Die zweiteilige Ausbildung der Löthilfe, insbesondere die Verschiebbarkeit des Innenteils innerhalb der Aufnahme des Außenteils, ermöglicht die Ausbildung einer Einführstellung, bei der eine Einführöffnung des Innenteils mit einer Einführöffnung des Außenteils zur Einführung der Litze des Kabels ausgerichtet ist, so dass die Litze im Wesentlichen gerade, parallel zu der Oberfläche der Kontaktfläche ausgerichtet, eingeführt werden kann. Die Position des Innenteils in Bezug auf das Außenteil kann in der Einführstellung abweichend sein von der Position des Innenteils in Bezug auf das Außenteil in der Montagestellung, insbesondere kann durch ein Verschieben des Innenteils ausgehend von der Einführstellung die Montagestellung erreicht werden. Die Montagestellung kann insbesondere eine Endstellung des Innenteils in Bezug auf das Außenteil darstellen, in der das Innenteil innerhalb der Aufnahme des Außenteils nicht weiter verschoben werden kann und in der das Innenteil an dem Außenteil festgelegt ist. Bei dem Festlegen des Innenteils an dem Außenteil wird die Litze an der Kontaktfläche fixiert. Das Außenteil weist eine Auflagefläche auf, mit der das Außenteil auf der Oberfläche der Leiterplatte positioniert werden kann.

Vorzugsweise ist für die Löthilfe vorgesehen, dass das Innenteil an einer Außenseite abschnittsweise mit einem Abschnitt der Innenseite der Aufnahme des Außenteils ein Führungsflächenpaar ausbildet. Das mindestens eine Führungsflächenpaar erleichtert die definierte Verschiebbarkeit des Innenteils in Bezug auf das Außenteil, da ein Verkanten des Innenteils in der Aufnahme vermieden werden kann und eine Reibung des Innenteils an dem Außenteil reduziert wird. Das mindestens eine Führungsflächenpaar wird dabei zwischen dem Innenteil und dem Außenteil entlang des gesamten Verschiebewegs vorgesehen. Die Ausbildung des mindestens einen Führungsflächenpaars verhindert weiter ein Verkanten des Innenteils in Bezug auf die Innenseite der Aufnahme des Außenteils während dem Verschieben des Innenteils.

Hinsichtlich der Ausbildung des mindestens einen Führungsflächenpaars ist vorzugsweise vorgesehen, dass der das Führungsflächenpaar ausbildende Abschnitt der Außenseite des Innenteils im Wesentlichen zylindrisch ausgebildet ist. Der zylindrisch ausgebildete Abschnitt an der Außenseite des Innenteils kann dabei beispielsweise mit einem flachen Abschnitt an der Innenseite des Außenteils das mindestens eine Führungsflächenpaar ausbilden; in diesem Fall wird das mindestens eine Führungsflächenpaar durch einen im Wesentlichen linienhaften, sich entlang des Verschiebewegs des Innenteils in Bezug auf das Außenteil erstreckenden Flächenabschnitt gebildet.

Für die Löthilfe ist vorzugsweise weiter vorgesehen, dass das Innenteil an dem Außenteil in der Montagestellung mittels einer Rastverbindung befestigbar ist. Damit lassen sich zusätzliche Mittel zur Festlegung des Innenteils an dem Außenteil vermeiden, so dass der Aufbau vereinfacht wird. Weiter lässt sich die Befestigung des Innenteils an dem Außenteil automatisch erzielen, sobald das Innenteil in Bezug auf das Außenteil die Montagestellung erreicht.

Für die Ausgestaltung der Rastverbindung ist vorzugsweise vorgesehen, dass an der Außenseite des Innenteils ein Rastvorsprung ausgebildet ist, der mit einer Hinterschneidung an der Innenseite des Außenteils die Rastverbindung ausbildet.

Für die Festlegung der Löthilfe an der Leiterplatte ist vorzugsweise vorgesehen, dass an dem Außenteil und / oder an dem Innenteil ein Befestigungsmittel für die Festlegung der Löthilfe an der Leiterplatte vorgesehen ist. Die Ausbildung eines Abschnitts des Außenteils und / oder des Innenteils als Befestigungsmittel ermöglicht den Verzicht auf zusätzliche Mittel zu Befestigung wie Schrauben oder Stifte, die ansonsten eine automatisierte Festlegung der Löthilfe auf der Oberfläche der Leiterplatte aufwendig machen.

Für die Ausbildung des Befestigungsmittels ist in einer bevorzugten Ausgestaltung vorgesehen, dass das Befestigungsmittel durch die Verschiebung des Innenteils in die Montagestellung betätigbar ist.

Das Befestigungsmittel kann vorzugsweise so ausgestaltet sein, dass das Befestigungsmittel an dem Außenteil als Spreizelement mit zwei oder mehr Spreizlaschen unter Ausbildung eines Spreizspaltes ausgebildet ist, und wobei an dem Innenteil ein Spreizstift ausgebildet ist, der, in der Montagestellung, den Spreizspalt derart ausfüllt, dass die Spreizlaschen gegen die Leiterplatte verspannbar sind.

Für die Löthilfe ist vorzugsweise weiter vorgesehen, dass das Innenteil in Bezug auf das Außenteil in eine Fixierstellung verschiebbar ist, und wobei in der Fixierstellung das Innenteil und das Außenteil eine vorfixierte Baueinheit ausbilden.

Das Vorsehen einer Fixierstellung ermöglicht eine bevorzugte Durchführung des Verfahrens derart, dass die Löthilfe in der Fixierstellung, in der das Innenteil und das Außenteil eine vorfixierte Baueinheit ausbilden, bereitgestellt und vor dem Einführen der Litze die Baueinheit auf der Leiterplatte angeordnet wird. Die vorfixierte Baueinheit wird dabei zuerst auf der Leiterplatte angeordnet, dann die Litze in der Fixierstellung eingeführt. Die Fixierstellung kann bereits der Montagestellung entsprechen, in der das Innenteil an dem Außenteil befestigt ist und in der das Außenteil an der Leiterplatte befestigt ist. Alternativ hierzu kann die Baueinheit aus der Fixierstellung durch ein weiteres Verschieben des Innenteils in Bezug auf das Außenteil in die Montagestellung verbracht werden.

Die vorfixierte Baueinheit kann unabhängig von der Montagesituation hergestellt und zur Fixierung der Litze auf der Kontaktfläche der Leiterplatte bereitgestellt werden.

Für die Löthilfe ist insbesondere in Hinblick auf die vorgenannte Fixierstellung vorzugsweise vorgesehen, dass an der Außenseite des Innenteils ein Fixierabschnitt ausgebildet ist, und wobei an der Innenseite des Außenteils ein zu dem Fixierabschnitt im Wesentlichen komplementärer Aufnahmeabschnitt ausgebildet ist, und wobei in einer Fixierstellung der Fixierabschnitt im Wesentlichen formschlüssig in dem Aufnahmeabschnitt aufgenommen ist. Der Fixierabschnitt erstreckt sich nur entlang eines definierten Teilbereichs des Verschiebewegs des Innenteils in Bezug auf das Außenteil und entspricht einer definierten, reproduzierbar einstellbaren Position des Innenteils relativ zu dem Außenteil. Der Fixierabschnitt kann insbesondere als Überstand von definierter Form an der Außenseite des Innenteils vorgesehen sein, wobei der Überstand mit einer Einsenkung von komplementärer Form an der Innenseite des Außenteils zusammenwirkt. Es versteht sich, dass der Überstand auch an der Innenseite des Außenteils vorgesehen sein kann und mit einer komplementären Einsenkung an der Außenseite des Innenteils zusammenwirkt, um eine abschnittsweise formschlüssige Festlegung des Innenteils an dem Außenteil zu ermöglichen.

Für die Ausbildung des Fixierabschnitts ist vorzugsweise vorgesehen, dass der Fixierabschnitt als Noppen und der Aufnahmeabschnitt als Vertiefung mit einer zu dem Noppen komplementären Form ausgebildet sind.

Für die Löthilfe, insbesondere für das Innenteil der Löthilfe, ist vorzugsweise vorgesehen, dass die Einführöffnung des Innenteils als in Richtung der Verschiebung offene Nut ausgebildet ist. Während des Verschiebens des Innenteils in Bezug auf das Außenteil nimmt die Nut einen Abschnitt der Litze bzw. des an die Litze angrenzenden Mantels des Kabels auf.

Weiter ist für die Löthilfe, insbesondere für das Außenteil der Löthilfe, vorzugsweise vorgesehen, dass die Einführöffnung des Außenteils als Durchgangsbohrung ausgebildet ist. Die Durchgangsbohrung ist dabei allseitig von dem Material des Außenteils umgeben ausgebildet, so dass die in der Durchgangsbohrung aufgenommene Litze einen definierten Abstand zu der Oberfläche der Leiterplatte einhält.

Ebenso ist vorzugsweise vorgesehen, dass in der Montagestellung die Einführöffnung des Innenteils versetzt in Bezug auf die Einführöffnung des Außenteils angeordnet ist. Aufgrund des Versatzes wird es möglich, dass die Litze mit einem Knick eingespannt wird, der zwischen der Einführöffnung des Außenteils und der Einführöffnung des Innenteils ausgebildet wird, wobei der Knick den Vorteil bietet, die Litze mit einer zusätzlichen Sicherung gegen Zugkräfte in der Löthilfe einzuspannen.

Zusätzlich kann für die Löthilfe vorgesehen sein, dass der Einführöffnung des Innenteils in Richtung der Erstreckung der Litze gegenüberliegend eine Zusatz-Einführöffnung vorgesehen ist. Die Zusatz-Einführöffnung kann insbesondere vorgesehen sein, um das freie Ende der Litze aufzunehmen und einzuspannen, so dass die Litze an zwei in Längsrichtung der Litze beabstandeten Punkten eingespannt auf der Kontaktfläche fixiert gehalten werden kann.

Weiter ist für das Innenteil oder das Außenteil, insbesondere sowohl für das Innenteil als auch das Außenteil, vorzugsweise vorgesehen, dass das Innenteil und / oder das Außenteil als einstückiges Formteil aus einem Metall oder einem Kunststoff, insbesondere als Kunststoff-Spritzgussteil ausgebildet ist. Das einstückige metallische Formteil kann insbesondere durch ein Fräsen oder eine Drahterosion hergestellt sein.

Abschließend ist für die Löthilfe in einer bevorzugten Ausgestaltung vorgesehen, dass in der Montagestellung das Innenteil vollständig innerhalb der Aufnahme des Außenteils aufgenommen ist.

Die Erfindung betrifft weiter eine Baugruppe, umfassend eine Leiterplatte und eine Litze eines Kabels, wobei die Litze mittels einer erfindungsgemäß ausgebildeten Löthilfe auf einer Kontaktfläche der Leiterplatte befestigt ist.

Weitere Vorteile und Merkmale der Erfindung ergeben sich aus den abhängigen Ansprüchen sowie aus der nachfolgenden Beschreibung mindestens eines Ausführungsbeispiels.

Die Erfindung wird im Folgenden unter Bezugnahme auf die anliegenden Zeichnungen näher beschrieben und erläutert.
- Fig. 1: zeigt eine perspektivische Ansicht eines Außenteils eines Ausführungsbeispiels einer erfindungsgemäßen Löthilfe,
- Fig. 2: zeigt eine Draufsicht auf das Außenteil aus Fig. 1,
- Fig. 3: zeigt eine perspektivische Ansicht eines Innenteils des in Fig. 1 und in Fig. 2 ausschnittsweise dargestellten Ausführungsbeispiels der erfindungsgemäßen Löthilfe,
- Fig. 4: zeigt eine perspektivische Ansicht des Innenteils aus Fig. 3, in einer 180° gedrehten Ansicht,
- Fig. 5: zeigt eine Unteransicht des in Fig. 3 und Fig. 4 dargestellten Innenteils,
- Fig. 6: zeigt eine perspektivische Ansicht des in Fig. 1 bis Fig. 5 dargestellten Ausführungsbeispiels der erfindungsgemäßen Löthilfe, bei der Herstellung eines Ausführungsbeispiels einer erfindungsgemäßen Baugruppe, sowie einen Verfahrensschritt bei einer beispielhaften Durchführung des erfindungsgemäßen Verfahrens,
- Fig. 7: zeigt eine perspektivische Ansicht des in Fig. 1 bis Fig. 6 dargestellten Ausführungsbeispiels der erfindungsgemäßen Löthilfe, bei der Herstellung der erfindungsgemäßen Baugruppe aus Fig. 6, sowie einem weiteren Verfahrensschritt bei der beispielhaften Durchführung des erfindungsgemäßen Verfahrens in Anschluss an Fig. 6,
- Fig. 8: zeigt eine geschnittene perspektivische Ansicht des in Fig. 1 bis Fig. 7 dargestellten Ausführungsbeispiels der erfindungsgemäßen Löthilfe,
- Fig. 9: zeigt eine teilweise geschnittene Ansicht des in Fig. 1 bis Fig. 8 dargestellten Ausführungsbeispiels der erfindungsgemäßen Löthilfe sowie des in Fig. 6 und Fig. 7 dargestellten Ausführungsbeispiels der erfindungsgemäßen Baugruppe, sowie einen weiteren Verfahrensschritt bei der beispielhaften Durchführung des erfindungsgemäßen Verfahrens,
- Fig. 10: zeigt eine teilweise geschnittene Ansicht des in Fig. 1 bis Fig. 9 dargestellten Ausführungsbeispiels der erfindungsgemäßen Löthilfe, der in Fig. 6, 7 und 9 dargestellten Baugruppe sowie einen weiteren Verfahrensschritt bei der beispielhaften Durchführung des erfindungsgemäßen Verfahrens,
- Fig. 11: zeigt eine perspektivische Ansicht eines ersten, zu dem in Fig. 1 bis Fig. 10 dargestellten Ausführungsbeispiels alternativen Ausführungsbeispiels einer erfindungsgemäßen Löthilfe und einer erfindungsgemäßen Baugruppe,
- Fig. 12: zeigt eine perspektivische Ansicht eines zweiten, zu dem in Fig. 1 bis Fig. 11 dargestellten Ausführungsbeispielen alternativen Ausführungsbeispiels einer erfindungsgemäßen Löthilfe und einer erfindungsgemäßen Baugruppe, und
- Fig. 13: zeigt eine perspektivische Ansicht des in Fig. 11 dargestellten ersten alternativen Ausführungsbeispiels, aus einer zu Fig. 11 abweichenden Blickrichtung.

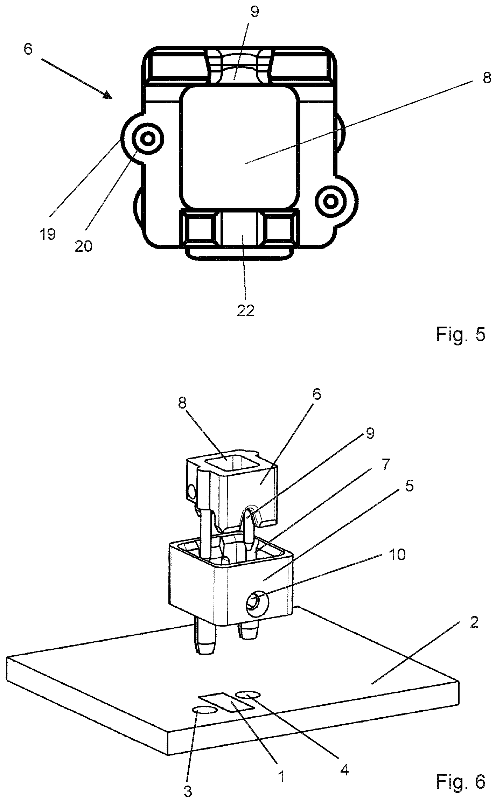

Fig. 6 zeigt eine perspektivische Ansicht einer Löthilfe, wobei die Löthilfe zum Fixieren einer Litze eines endseitig abgemantelten Kabels auf einer elektrischen Kontaktfläche 1 einer Leiterplatte 2 (PCB, printed circuit board, auch: Platine) ausgebildet ist. Mit der Kontaktfläche 1 sind elektronische Bausteine elektrisch leitend verbunden, die auf der Leiterplatte 2 angeordnet sind, bildlich aber nicht dargestellt sind.

Die Kontaktfläche 1 weist eine Längserstreckung auf, wobei zu beiden Seiten, in Richtung der Längserstreckung zueinander versetzt, zwei Aufnahmebohrungen 3, 4 für die Befestigung der Löthilfe an der Leiterplatte 2 vorgesehen sind.

Die Löthilfe weist in dem in Fig. 6 dargestellten, noch nicht vollständig montierten Zustand zwei anfangs noch baulich getrennt ausgebildete Bestandteile auf und umfasst ein Außenteil 5 mit einer Auflagefläche, mit der das Außenteil 5 auf der Oberfläche der Leiterplatte 2 in der montierten Endstellung aufliegt, sowie ein Innenteil 6. Das Außenteil 5 weist eine allgemein viereckige Außenkontur auf und umgibt mit seiner umlaufenden Wandung eine Öffnung, so dass eine Aufnahme 7 ausgebildet ist, die in der montierten Stellung der Löthilfe die Kontaktfläche 1 umgibt. Wie Fig. 6 zeigt, ist das Innenteil 6 in Bezug auf die Aufnahme 7 des Außenteils 5 so ausgerichtet angeordnet, dass das Innenteil 6 innerhalb der Aufnahme 7 des Außenteils 5 verschiebbar aufgenommen werden kann, wobei das Innenteil 6 in einer Richtung senkrecht zu der Oberfläche der Leiterplatte 2 hin zu der Leiterplatte 2 in die weiter unten näher beschriebene und erläuterte Montagestellung verschoben wird.

Das Innenteil 6 weist eine im Wesentlichen viereckige Außenkontur auf und umgibt mit einer Wandung einen Zugang 8, der als von der Wandung umlaufene Öffnung ausgebildet ist, wobei der Zugang 8 in der Montagestellung die Kontaktfläche 1 so umgibt, dass durch den Zugang 8 ein Zugriff, insbesondere das Einführen von Wärme in Form eines Wärmefingers oder mittels des Strahls eines Lasers, auf die Kontaktfläche 1 möglich ist. In der Montagestellung ist das Innenteil 6, das den Zugang 8 zu der Kontaktfläche 1 aufweist, an dem Außenteil 5 befestigbar.

Das Innenteil 6 weist eine Einführöffnung 9 an einer Unterkante einer der Seiten der Wandung auf, weiter weist das Außenteil 5 eine Einführöffnung 10 nahe der Unterkante der Seitenwand einer der Wandung auf. Aus Fig. 6 ist erkennbar, dass die Einführöffnung 9 des Innenteils 6 als in Richtung der Verschiebung, also hin zu der Oberfläche der Leiterplatte 2, offene Nut ausgebildet ist. Weiter ist erkennbar, dass die Einführöffnung 10 des Außenteils 5 als Durchgangsbohrung ausgebildet ist, dabei ist die Durchgangsbohrung nahe der Unterkante der Seite der Wandung des Außenteils 5 ausgebildet, und zwar so, dass die Durchgangsbohrung die Wandung von einer Außenseite des Außenteils 5 zu einer Innenseite des Außenteils 5 so durchsetzt, dass die Durchgangsbohrung von dem Material der Wandung der Seitenwand umgeben ist. Dagegen ist die Einführöffnung 9 des Innenteils 6 als einseitig offene Nut ausgebildet.

In einer weiter unten näher beschriebenen Einführstellung ist die als zu der Leiterplatte 2 hin offene Nut ausgebildete Einführöffnung 9 des Innenteils 6 mit der als Durchgangsbohrung ausgebildeten Einführöffnung 10 des Außenteils 5 zur Einführung der Litze des Kabels so ausgerichtet, dass die Litze des Kabels im Wesentlichen parallel zu der Oberfläche der Leiterplatte 2 und in einem Abstand zu der Oberfläche der Leiterplatte 2 in die Löthilfe eingeführt werden kann.

In dem dargestellten Ausführungsbeispiel ist vorgesehen, dass das Innenteil 6 und das Außenteil 5 als jeweils einstückiges Formteil, insbesondere als Kunststoff-Spritzgussteil ausgebildet sind. In einer Abwandlung des dargestellten Ausführungsbeispiels kann vorgesehen sein, dass das Innenteil und / oder das Außenteil, insbesondere sowohl das Innenteil als auch das Außenteil als einstückiges metallisches Formteil ausgebildet ist, das beispielsweise mittels Fräsen oder Drahterodieren hergestellt ist. Das metallische Formteil kann insbesondere den Wärmeeintrag bei dem Aufschmelzen des Lots gut aufnehmen und ableiten.

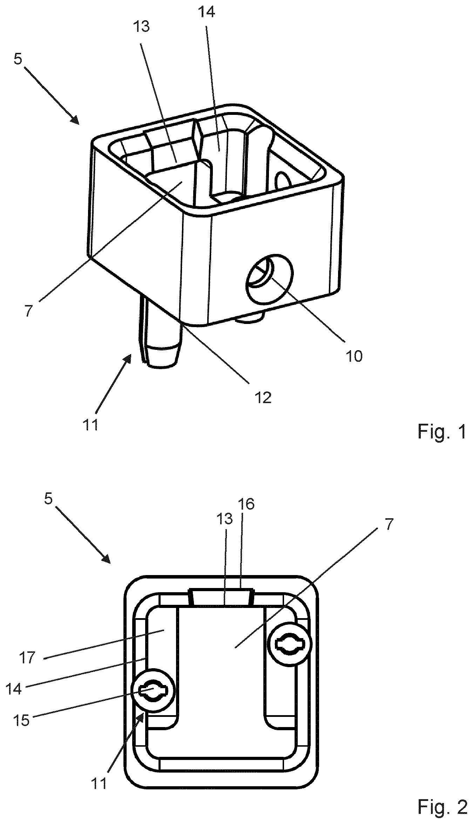

Fig. 1 zeigt das Außenteil 5 der Löthilfe in einer perspektivischen Darstellung. Es ist erkennbar, dass an dem Außenteil 5 ein Befestigungsmittel für die Festlegung des Außenteils 5 der Löthilfe an der Leiterplatte vorgesehen ist. In der montierten Stellung, in der das Innenteil 6 an dem Außenteil 5 der Löthilfe befestigt ist, sind damit sowohl das Außenteil 5 unmittelbar als auch das Innenteil 6 mittelbar an der Leiterplatte befestigt.

Das Befestigungsmittel umfasst zwei Spreizelemente an zwei gegenüberliegenden Seitenwänden der Wandung des Außenteils 5, wobei die Spreizelemente gleichartig ausgebildet sind, und nur das mit dem Bezugszeichen ,11' ausgewiesene Spreizelement näher beschrieben werden soll.

Das an dem Außenteil 5 vorgesehene Befestigungselement ist als Spreizelement 11 mit zwei Spreizlaschen unter Ausbildung eines Spreizspaltes ausgebildet. Eine der Spreizlaschen ist mit dem Bezugszeichen ,12' ausgewiesen, die andere Spreizlasche ist von der vorderen Spreizlasche im Wesentlichen verdeckt. Die beiden Spreizlaschen liegen einander gegenüber und bilden zueinander einen Spreizspalt aus und laufen zu den jeweiligen Enden hin konisch zu. An einer Außenseite weist die jeweilige Spreizlasche eine abschnittsweise zylindrische Kontur auf, derart, dass die jeweilige Spreizlasche in eine der Aufnahmebohrungen 3, 4 (Fig. 6) in der Leiterplatte eingeführt werden kann und abschnittsweise formschlüssig an der Innenwandung der Aufnahmebohrung anliegen kann. Die aufeinander zu weisenden Innenseiten der Spreizlaschen weisen jeweils eine abschnittsweise hohlzylindrische Innenkontur auf, derart, dass ein an dem Innenteil ausgebildeter Spreizstift in der Montagestellung den Spreizspalt derart ausfüllt, dass die Spreizlaschen gegen die Leiterplatte, nämlich gegen die Innenwandung der Aufnahmebohrung, verspannbar sind.

Die beiden Spreizlaschen 12 sind jeweils an der Unterkante der die Aufnahme 7 umlaufenden Wandung ausgebildet und stehen in Richtung auf die Oberfläche der Leiterplatte im Wesentlichen senkrecht zu der Auflagefläche der Unterkante der Wandung um jeweils den gleichen Abstand vor. Jede der beiden Spreizlaschen 12 weist an der Außenseite an dem jeweiligen Ende eine konische Anschrägung auf, um das Einführen der Spreizlasche 12 in die Aufnahmebohrung 3, 4 in der Leiterplatte 2 zu vereinfachen.

Fig. 1 zeigt weiter eine Hinterschneidung 13 an der Innenseite 14 des Außenteils 5, die einen Teil einer Rastverbindung zum Befestigen des Innenteils an dem Außenteil 5 bildet. Fig. 1 zeigt ebenfalls die als Durchgangsbohrung ausgebildete Einführöffnung 10, es ist erkennbar, dass die Einführöffnung 10 und die Hinterschneidung 13 an gegenüberliegenden Seitenwänden der Wandung des Außenteils 5 angeordnet sind.

Fig. 2 zeigt das Außenteil 5 der Löthilfe in einer Draufsicht, in einer Blickrichtung auf die Leiterplatte. Erkennbar ist ein Spreizspalt 15 zwischen den beiden einander gegenüberliegenden Spreizlaschen des Spreizelements 11, sowie weiter die abschnittsweise hohlzylindrische Innenkontur einer jeden der Spreizlaschen 12 auf den einander gegenüberliegenden Innenseiten der Spreizlaschen 12.

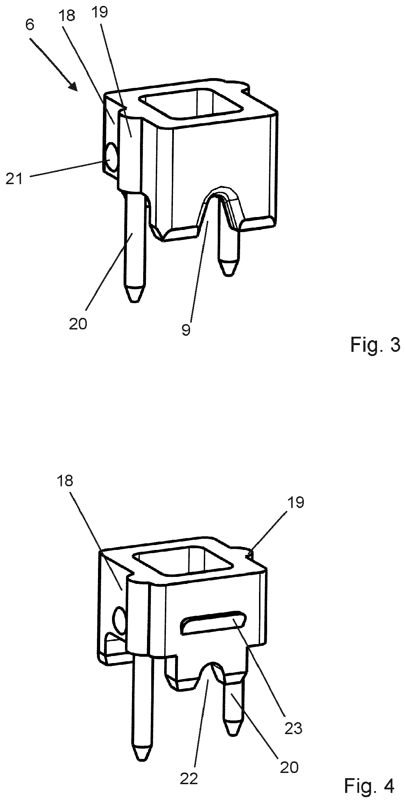

Die Draufsicht aus Fig. 2 lässt weiter erkennen, dass von einer Oberkante des Außenteils 5 in Richtung auf die Unterkante des Außenteils 5 sich eine Führungsnut 16 an der Innenseite 14 des Außenteils erstreckt, wobei die Führungsnut 16 bis zu der Hinterschneidung 13 reicht, derart, dass der mit der Hinterschneidung 13 zur Ausbildung der Rastverbindung zusammenwirkende Rastvorsprung an dem Innenteil (Fig. 3, 4) durch die Führungsnut 16 geführt wird, bis bei Erreichen der Montagestellung die Rastverbindung zwischen den Innenteil 6 und dem Außenteil 5 durch das Hintergreifen der Hinterschneidung 13 durch den Rastvorsprung hergestellt wird.

Fig. 2 ist weiter zu entnehmen, dass in der Aufnahme 7 an zwei gegenüberliegenden Seitenwänden jeweils ein Absatz ausgebildet ist, und an einander gegenüberliegenden Seitenwänden der Innenseite 14, die die Aufnahme 7 umgrenzt. Einer der beiden Absätze ist mit dem Bezugszeichen ,17' und dient mit dem gegenüberliegenden Absatz als Anschlag, der das Verschieben des Innenteils 6 in dem Außenteil 5 in der Aufnahme, senkrecht in die Papierebene der Darstellung aus Fig. 2 hinein, begrenzt. Hierzu weist eine Unterkante des Innenteils 6 einen Anschlagabschnitt auf, der mit dem Absatz 17 zusammenwirkt. Die Vergrößerung der Wanddicke im Bereich der Absätze 17 des Außenteils 5 dient dazu, die Spreizelemente 11 auszubilden, beispielsweise, indem Material aus den Absätzen 17 so verdrängt wird, dass die Spreizlaschen 12 der Spreizelemente 11 ausgebildet werden können.

Fig. 2 lässt weiter erkennen, dass die Aufnahme 7 des Außenteils 5 als von den Seitenwänden der Wandung des Außenteils 5 umgebene Öffnung ausgebildet ist.

Fig. 3 zeigt das Innenteil 6 der Löthilfe in einer perspektivischen Ansicht. Es ist erkennbar, dass an einer Außenseite 18 des Innenteils 6 zwei zylindrische Abschnitte ausgebildet sind, die gleichartig ausgebildet sind und von denen einer mit dem Bezugszeichen ,19' ausgewiesen ist. Der zylindrische Abschnitt 19 wirkt mit einem Abschnitt an der Innenseite des Außenteils 5 so zusammen, dass ein Führungsflächenpaar mit einem mit dem zylindrischen Abschnitt 19 während des Verschiebens des Innenteils 6 relativ zu dem Außenteil 5 dauerhaft in Kontakt stehenden Abschnitt der Innenseite 14 der Aufnahme 7 des Außenteils ausgebildet wird. Dazu erstreckt sich der zylindrische Abschnitt 19 von der Oberkante des Innenteils 6 entlang des gesamten Verschiebewegs des Innenteils 6 in dem Außenteil 5 bis zu der unteren Begrenzung des Innenteils 6. Es ist insbesondere erkennbar, dass das Innenteil 6 an der Außenseite 18 abschnittsweise mit einem Abschnitt der Innenseite der Aufnahme 7 des Außenteils 5 ein Führungsflächenpaar ausbildet, wobei der das Führungsflächenpaar ausbildende Abschnitt 19 der Außenseite 18 des Innenteils 6 im Wesentlichen zylindrisch ausgebildet ist. Insbesondere werden zwei Führungsflächenpaare ausgebildet, die an einander gegenüberliegenden Seitenwänden des Innenteils 6 bzw. des Außenteils 5 ausgebildet sind.

Fig. 3 zeigt weiter, dass an dem Innenteil 6 zwei Spreizstifte ausgebildet sind, die gleichartig ausgebildet sind, und von denen einer mit dem Bezugszeichen ,20' versehen ist. Der jeweilige Spreizstift 20 steht von einer unteren Begrenzung des Innenteils 6 im Wesentlichen senkrecht zu der Oberfläche der Leiterplatte 2 hin gerichtet ab und wirkt mit dem jeweiligen Spreizspalt 15 des jeweiligen Spreizelements 11 an dem Außenteil 5 derart zusammen, dass in der Montagestellung, der jeweilige Spreizstift 20 den jeweiligen Spreizspalt 15 zwischen den paarweise gegenüberliegenden Spreizlaschen 12 derart ausfüllt, dass die Spreizlaschen 12 gegen die Leiterplatte 2 verspannt werden. Damit wird in der Montagestellung das Außenteil 5 an der Leiterplatte 2 festgelegt.

Der jeweilige Spreizstift 20 ist dabei als endseitig konisch zulaufender, zylindrischer Zapfen ausgebildet, wobei der zylindrische Zapfen einen Durchmesser aufweist, der in Bezug auf den Durchmesser des Spreizspaltes 15 (Fig. 2) ein geringes Übermaß aufweist, das so bemessen ist, dass der Spreizstift 20 die Spreizlaschen 12 eines jeden der Spreizelemente 11 gegen die Innenwandung der Aufnahmebohrungen 3, 4 in der Leiterplatte 2 verstemmt. Insbesondere ist möglich, dass das Befestigungsmittel, nämlich das mindestens eine Spreizelement 11, durch ein Verschieben des Spreizstiftes 20 in den Spreizspalt 15 in eine Endstellung bewirkt, dass das Außenteil 5 an der Leiterplatte 2 festgelegt wird. Hierzu ist vorgesehen, dass das Befestigungsmittel durch die Verschiebung des Innenteils 6, mit dem der jeweilige Spreizstift 20 einstückig ausgebildet ist, in die Montagestellung betätigbar ist, so dass in der Endstellung des Spreizstiftes 20 in dem Spreizspalt 15 das Befestigungselement, nämlich das Spreizelement 11, das Außenteil 5 an der Leiterplatte endgültig und unlösbar festlegt. Insbesondere ist erst in der Endstellung des jeweiligen Spreizstiftes 20 in dem Spreizspalt 15 das Spreizelement 11 an der Leiterplatte befestigt und damit betätigt, während vor dem Erreichen der Endstellung das Spreizelement 11 und damit das Außenteil 5 an der Leiterplatte noch lösbar angeordnet bleibt.

Fig. 3 zeigt weiter die Einführöffnung 9 des Innenteils 6, die als zu der Leiterplatte 2, also in Richtung der Verschiebung des Innenteils 6 in Bezug auf das Außenteil 5, hin offene Nut ausgebildet ist.

Fig. 3 zeigt ebenfalls, dass an der Außenseite 18 des Innenteils 6 ein Fixierabschnitt ausgebildet ist; der Fixierabschnitt ist insbesondere als Noppen 21 ausgebildet. Das Innenteil 6 weist an zwei gegenüberliegenden Seitenwänden an der Außenseite 18 jeweils einen als Noppen 21 ausgebildeten Fixierabschnitt aus, wobei nur einer der beiden Noppen mit dem Bezugszeichen ,21' ausgewiesen ist. Der jeweilige Noppen 21 steht über die im Wesentlichen flache Außenseite 18 der jeweiligen Seitenwand über und wirkt mit einem komplementären Aufnahmeabschnitt an der Innenseite des Außenteils 5 zusammen. Dabei ist vorgesehen, dass an der Innenseite 14 des Außenteils 5 ein zu dem Fixierabschnitt, nämlich dem jeweiligen Noppen 21, im Wesentlichen komplementärer Aufnahmeabschnitt ausgebildet ist, wobei der Aufnahmeabschnitt als zu dem Noppen 21 komplementäre Einsenkung in der Innenseite 14 des Außenteils 5 ausgebildet ist. In einer Fixierstellung ist der Fixierabschnitt, nämlich der jeweilige Noppen 21, im Wesentlichen formschlüssig in dem Aufnahmeabschnitt mit einer zu dem Noppen 21 komplementären Form, nämlich in der zu dem Noppen 21 komplementären Vertiefung oder Einsenkung, aufgenommen.

Fig. 4 zeigt das Innenteil 6 in einer in Vergleich zu der Darstellung aus Fig. 5 um ca. 180° gedrehten Ansicht.

Erkennbar ist, dass der Einführöffnung 9 des Innenteils 6 in Richtung der Erstreckung der Litze gegenüberliegend eine Zusatz-Einführöffnung 22 vorgesehen ist. Die Zusatz-Einführöffnung 22 ist als zu der Oberfläche der Leiterplatte 2 hin, also in Richtung der Verschiebung des Innenteils 2 hin zu der Montagestellung, offene Nut ausgebildet. Die Zusatz-Einführöffnung 22 ist an einer Unterkante der Seitenwand ausgebildet, die der Seitenwand, in der die Einführöffnung 9 ausgebildet ist, gegenüberliegt.

Die Zusatz-Einführöffnung 22 kann, zusammen mit der Einführöffnung 9 des Innenteils 6, die Litze an zwei Abschnitten aufnehmen und fixieren, beispielsweise kann vorgesehen sein, dass die Einführöffnung 9 die Litze nahe der Mantelkante des abgemantelten Abschnitts des Kabels fixiert, und die die Zusatz-Einführöffnung 22 die Litze in einem von der Mantelkante entfernten Abschnitt, beispielsweise das freie Ende der Litze fixiert oder einen Zwischenabschnitt der Litze zwischen dem freien Ende der Litze und dem der Mantelkante nahen Abschnitt der Litze.

Fig. 4 zeigt weiter, dass an der Außenseite 18 des Innenteils 6 ein Rastvorsprung 23 ausgebildet ist, der mit der Hinterschneidung 13 an der Innenseite 14 des Außenteils 5 (Fig. 1, 2) die Rastverbindung ausbildet. Aufgrund des Zusammenwirkens des Rastvorsprungs 23 mit der Hinterschneidung 13 wird ermöglicht, dass bei Erreichen der Montagestellung das Innenteil 6 an dem Außenteil 5 in der Montagestellung mittels der Rastverbindung befestigbar ist.

Der Rastvorsprung 23 ist als sich quer zu der Richtung der Verschiebung des Innenteils 6 erstreckende, über die im Wesentlichen flache angrenzende Außenseite 18 in Richtung auf die Innenseite 14 des Außenteils 5 vorstehende Anformung, ggf. auch als freigeschnittene Lasche, ausgebildet.

Fig. 5 zeigt eine Unteransicht auf das Innenteil 6, in einer Blickrichtung weg von der Oberfläche der Leiterplatte 2 im Wesentlichen entlang einer Mittenachse des Zugangs 8.

Es ist erkennbar, dass die Zusatz-Einführöffnung 22 der Einführöffnung 9 entlang einer gedachten Linie, die der Längserstreckung der freigelegten Litze entspricht, gegenüberliegt. Weiter ist eine Ansicht der endseitig konisch zulaufenden Spreizstifte 20 möglich, die in einer Verlängerung der zylindrischen Abschnitte 19 ausgebildet sind. Weiter ist erkennbar, dass die Noppen 21 auf der Außenseite der gleichen Seitenwand angeordnet sind, an der auch die Spreizstifte 20 sowie die zylindrischen Abschnitte 19 ausgebildet sind. Ersichtlich ist ferner, dass der Zugang 8 eine im Wesentlichen rechteckige Umfangskontur aufweist, durch die hindurch in der Montagestellung ein Zugriff auf die mindestens abschnittsweise innerhalb der Öffnung des Zugangs 8 aufgenommene Kontaktfläche für zum Beispiel einen Laserstrahl oder einen Wärmefinger, jeweils zur Zufuhr von thermischer Energie zum Aufschmelzen des Lotmaterials, möglich ist.

Fig. 6 zeigt das Außenteil 5 sowie das Innenteil 6, die noch als getrennte Bauteile bereitgestellt sind.

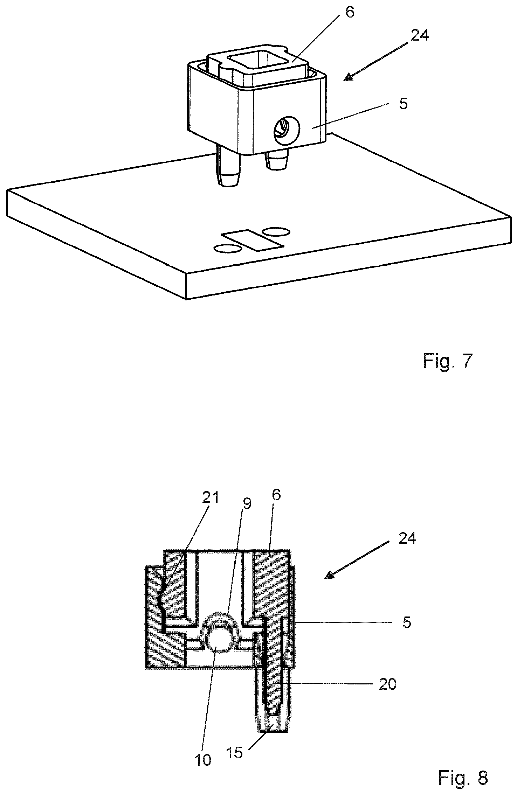

Fig. 7 zeigt eine vorfixierte Baueinheit 24, wobei vorgesehen ist, dass wobei das Innenteil 6 in Bezug auf das Außenteil 5 in eine Fixierstellung verschoben ist, und wobei in der Fixierstellung das Innenteil 6 und das Außenteil 5 die vorfixierte Baueinheit 24 ausbilden. In der Fixierstellung lassen sich das Innenteil 6 und das Außenteil 5 nur unter einem definierten Kraftaufwand voneinander trennen, so dass die vorfixierte Baueinheit 24 als vorgefertigtes Bauteil bereitgestellt werden kann.

Fig. 8 zeigt einen Schnitt durch die vorfixierte Baueinheit 24. Es ist erkennbar, dass die Löthilfe in der Fixierstellung die Noppen 21 an dem Innenteil 6 in die zu den Noppen 21 komplementären Ausnehmungen an dem Außenteil 5 eingreifen und auf diese Weise die grundsätzlich noch lösbare Vorfixierung des Innenteils 6 an dem Außenteil 5 ermöglichen. Weiter ist erkennbar, dass der Spreizstift 20 an dem Innenteil 6 in den Spreizspalt 15 eingeführt, jedoch noch nicht bis in eine Endstellung verschoben worden ist. Ersichtlich ist weiter, dass in dem dargestellten Ausführungsbeispiel bereits in der Fixierstellung die Einführöffnung 9 des Innenteils 6 mit der Einführöffnung 10 des Außenteils 5 im Wesentlichen fluchtend ausgerichtet ist, derart, dass die gerade ausgerichtete Litze durch beide Einführöffnungen 9, 10 eingeführt werden kann. Entsprechend ist auch die Zusatz-Einführöffnung 22 (Fig. 4, 5) zu den beiden Einführöffnungen 9, 10 fluchtend ausgerichtet (in Fig. 8 oberhalb der Papierebene).

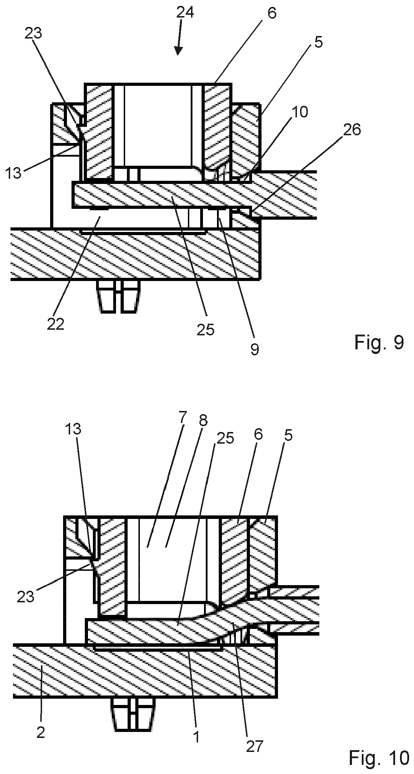

Fig. 9 zeigt die Löthilfe bzw. die in Fig. 8 dargestellte Baueinheit 24 in einer Einführstellung, wobei in der Einführstellung die Einführöffnung 9 des Innenteils 6 mit der Einführöffnung 10 des Außenteils 5 zur Einführung der Litze 25 des Kabels ausgerichtet ist. Es ist weiter erkennbar, dass die Einführöffnung 10 des Außenteils 5 konisch zulaufend ausgebildet ist, so dass eine Mantelkante 26 aufgenommen und abgestützt werden kann, hierzu liegt die Mantelkante 26 auf der konisch zulaufenden Fläche der Einführöffnung 10 des Außenteils 5 auf. Weiter ist ersichtlich, dass die Litze 25 ebenfalls die Zusatz-Einführöffnung 22 in dem Innenteil 6 durchsetzt. In der Einführstellung durchsetzt die Litze 25 des Kabels die zueinander ausgerichteten, insbesondere miteinander fluchtenden Einführöffnungen 9, 10 des Innenteils 6 bzw. des Außenteils 5 im Wesentlichen gerade. Das Kabel mit der Litze 25 wird dabei von einem Greifer eines Roboterarms gehalten und in Einführrichtung bewegt.

In einer Abwandlung des dargestellten Ausführungsbeispiels ist vorgesehen, dass die Einführöffnung des Außenteils nicht konisch zulaufend ausgebildet ist, sondern beispielsweise zylindrisch ausgebildet ist, aber eine Stufe aufweist, wobei im Bereich der Stufe der Durchmesser sprungartig abnimmt, derart, dass die Stufe als Einführanschlag wirkt, wenn die Mantelkante an der Stufe zur Anlage kommt.

In der Darstellung von Fig. 9 ist ersichtlich, dass der Rastvorsprung 23 an dem Innenteil 6 die Hinterschneidung 13 an dem Außenteil 5 noch nicht hintergriffen hat, so dass das Außenteil 5 an dem Innenteil 6 noch nicht endgültig festgelegt ist. Aus der in Fig. 9 dargestellten Einführstellung könnte die Litze 25 grundsätzlich noch entgegen der Einführrichtung zurückbewegt werden.

Fig. 9 ist weiter zu entnehmen, dass in der Einführstellung mindestens das Außenteil 5 bereits so auf der Leiterplatte angeordnet ist, dass das Befestigungsmittel 11 die Aufnahmebohrung 3, 4 durchsetzt, ohne jedoch bereits an der Aufnahmebohrung 3, 4 befestigt zu sein. Fig. 9 stellt dabei einen Fall dar, bei dem vor dem Einführen der Befestigungsmittel 11 in die Aufnahmebohrungen 3, 4 die in Fig. 7, 8 dargestellte vorfixierte Baueinheit hergestellt worden ist, deren dann an dem Innenteil 6 vorfixiertes Außenteil 5 in die Aufnahmebohrungen 3, 4 eingesetzt ist.

Fig. 10 zeigt die Löthilfe in der endgültigen Montagestellung. Ausgehend von der in Fig. 9 dargestellten Einführstellung lässt sich die Löthilfe durch ein Verschieben des Innenteils 6 in Bezug auf das Außenteil 5 in eine Endstellung in die in Fig. 10 dargestellte Montagestellung verbringen.

Bei der Darstellung von Fig. 10 ist erkennbar, dass der Rastvorsprung 23 an dem Innenteil 6 die Hinterschneidung 13 an dem Außenteil hintergriffen hat, derart, dass das Außenteil 5 an dem Innenteil 6 befestigt ist. Aufgrund der Verschiebbarkeit des Innenteils 6 innerhalb der Aufnahme des Außenteils 5 ist es weiter möglich, dass die Litze 25 auf der Kontaktfläche 1 der Leiterplatte 2 angedrückt gehalten wird, so dass in einem nachfolgenden Verarbeitungsschritt die Litze 25 an der Leiterplatte 2 angelötet werden kann, hierzu ist durch den Zugang 8 in dem Innenteil ein Zugreifen auf die Litze möglich, um thermische Energie beispielsweise mittels eines Laserstrahls oder eines Wärmefingers zuzuführen.

Aus Fig. 10 ist weiter erkennbar, dass in der Montagestellung die Einführöffnung 9 des Innenteils 6 versetzt in Bezug auf die Einführöffnung 10 des Außenteils 5 angeordnet ist, mit der Folge, dass die Litze im Bereich der als zu der Leiterplatte 2 in Verschieberichtung hin offene Nut ausgebildeten Einführöffnung 9 des verschiebbar geführten Innenteils 6 einen im Wesentlichen gestreckt S-förmig gebogenen Abschnitt 27 aufweist. Die Litze 25 liegt damit, bezogen auf die Erstreckung des Kabels, auf der Kontaktfläche 1 in Vergleich zu der Erstreckungsrichtung des Kabels parallel versetzt auf. Der gebogene Abschnitt 27 der Litze 25 im Bereich der Löthilfe, insbesondere im Bereich der Einführöffnung 9 des Innenteils 6 in der Montageposition, bietet den Vorteil, die Litze 25 zusätzlich gegen Abzugskräfte zu sichern, so dass ein Herausziehen der Litze 25 entgegen der Einführrichtung deutlich erschwert wird. Die bei dem Herausziehen der Litze 25 auftretenden Abzugskräfte werden dabei durch das Innenteil 6, mittelbar also durch die Löthilfe, die in der Montagestellung ein unverlierbar gefügter Verbund aus dem zuvor baulich getrennt bereitgestellten Innenteil 6 und dem Außenteil 5 bildet, aufgenommen.

In Fig. 10 nicht erkennbar ist, dass durch das Verschieben des Innenteils 6 in Bezug auf das Außenteil 5 der Spreizstift 20 an dem Innenteil 6 in den Spreizspalt 15 der Spreizlaschen 12 des Spreizelements 11 an dem Außenteil 5 in seine Endstellung verbracht ist, so dass der Außenteil 5 und damit die Löthilfe insgesamt mittels des als betätigbaren Spreizelements 11 ausgebildeten Befestigungsmittels an der Leiterplatte 2 unverlierbar angeordnet ist, wie oben, mit Bezug auf Fig. 8 erläutert.

Fig. 10 zeigt weiter eine Baugruppe, umfassend die Leiterplatte 2 und die Litze 25 des Kabels, wobei die Litze 25 mittels der vorstehend beschriebenen Löthilfe auf der Kontaktfläche 1 der Leiterplatte 2 befestigt ist, und wobei insbesondere die Löthilfe in der Montagestellung als Verbund, gebildet durch das an dem Außenteil 5 befestigte Innenteil 6, das den Zugang 8 zu der Kontaktfläche 1 aufweist, ausgestaltet ist.

Bei der in Fig. 10 dargestellten Montagestellung der Löthilfe ist weiter erkennbar, dass das Innenteil 6 vollständig innerhalb der Aufnahme 7 des Außenteils 5 aufgenommen ist. Insbesondere steht eine Oberkante des Innenteils 6 nicht über die Oberkante des Außenteils 5 über, sondern schließt bündig mit dieser ab, so dann in einer Blickrichtung parallel zu der Ebene der Oberfläche der Leiterplatte 2 das Innenteil 6 innerhalb der Aufnahme 7 des Außenteils 5 nicht mehr zu erkennen ist.

Mit Bezug auf die vorstehend beschriebenen Fig. 6 bis Fig. 10 lässt sich eine bevorzugte Durchführung eines erfindungsgemäßen Verfahrens zum Fixieren einer Litze eines Kabels auf einer elektrischen Kontaktfläche 1 einer Leiterplatte 2 erläutern:
In einem ersten, beispielsweise in Fig. 6 dargestellten Verfahrensschritt werden das Außenteil 5 sowie das innerhalb der Aufnahme 7 des Außenteils 5 verschiebbare Innenteil 6 der Löthilfe als anfangs getrennte Bauteile bereitgestellt.

Eine mögliche Durchführung dieses ersten Verfahrensschritts kann vorsehen, dass das Außenteil 5 auf der Leiterplatte 2 positioniert wird und nachfolgend das Innenteil 6 in die Aufnahme 7 des Außenteils 5 eingebracht wird.

Eine hierzu alternative bevorzugte Durchführung des ersten Verfahrensschritts sieht vor, dass die Löthilfe in einer Fixierstellung bereitgestellt wird, dass zuerst das Innenteil 6 in die Aufnahme 7 des Außenteils 5 eingeführt wird und dann der Verbund als vorfixierte Baueinheit 24 bereitgestellt wird, wobei die vorfixierte Baueinheit 24 auf der Leiterplatte 2 positioniert wird, und zwar vor dem Einführen der Litze in die vorfixierte Baueinheit 24. Diese Durchführung des ersten Verfahrensschritts wurde oben mit Bezug auf Fig. 7, 8 erläutert.

In einem zweiten Verfahrensschritt, der oben mit Bezug auf Fig. 9 erläutert wurde, ist das Einführen der Litze des Kabels in einer Einführstellung vorgesehen, wobei in der Einführstellung die Einführöffnung 9 des Innenteils 6 mit der Einführöffnung 10 des Außenteils 5 zur Einführung der insbesondere gerade gestreckt ausgerichteten Litze ausgerichtet ist.

In einem dritten Verfahrensschritt, der oben mit Bezug auf Fig. 10 erläutert wurde, ist vorgesehen, das Innenteil 6 innerhalb der Aufnahme 7 des Außenteils insbesondere durch ein Verschieben in einer Richtung senkrecht zu der Oberfläche der Leiterplatte sowie senkrecht zu der Erstreckung der zuvor eingeführten Litze in eine Montagestellung zu verbringen. In dieser Montagestellung ist das Innenteil 6 an dem Außenteil 5 unverlierbar befestigt. Weiter lässt in dieser Montagestellung der Durchgang 8 des Innenteils 6 die elektrische Kontaktfläche 1 der Leiterplatte 2 so weit zugänglich, dass von außen thermische Energie, insbesondere in Laserstrahl, durch den Durchgang 8 des Innenteils 6 auf die Litze sowie die Kontaktfläche gelangen kann, um das Lotmaterial zu erwärmen und zu schmelzen. In der in dem dritten Verfahrensschritt erreichten endgültigen Montagestellung ist weiter das Außenteil 5 an der Leiterplatte 2 endgültig unverlierbar befestigt.

Die Erfindung wurde vorstehend mit Bezug auf Fig. 1 bis Fig. 10 anhand eines Ausführungsbeispiels beschrieben, bei dem die Löthilfe zur Aufnahme einer einzigen Litze 25 des Kabels vorgesehen war.

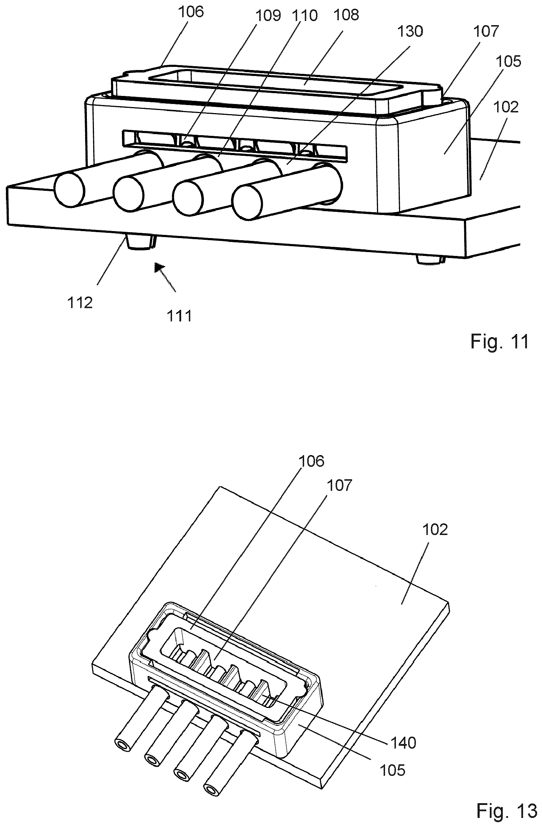

Fig. 11 zeigt eine Abwandlung einer Löthilfe, die zur Aufnahme und zum Fixieren von mehreren, in dem dargestellten ersten alternativen Ausführungsbeispiel von vier Litzen, von jeweils vier baulich getrennten Kabeln vorgesehen ist, wobei jeder der Litzen jeweils eine elektrische Kontaktfläche auf einer gemeinsamen Leiterplatte 102 zugeordnet ist.

Es ist erkennbar, dass die Löthilfe ein für alle Litzen gemeinsames Außenteil 105 mit einer Auflagefläche zur Auflage auf die Oberfläche der gemeinsamen Leiterplatte 102 umfasst, sowie weiter ein für alle Litzen gemeinsames Innenteil 106, das innerhalb einer gemeinsamen Aufnahme 107 des Außenteils 105 verschiebbar aufgenommen ist, wobei das Innenteil 106 einen für alle Litzen gemeinsamen Zugang 108 zu der Kontaktfläche aufweist. In einer Montagestellung ist das Innenteil 106 an dem Außenteil 105 befestigbar, beispielsweise mittels zwei an dem Außenteil 105 angeordneten Befestigungselementen 111, die jeweils als Spreizelemente 112 ausgebildet sind.

Bei dem Innenteil 106 ist für jede Litze eine eigene Einführöffnung vorgesehen, wobei nur eine der Einführöffnungen mit dem Bezugszeichen ,109' versehen ist. Jede der Einführöffnungen ist als offene Nut ausgebildet, so dass aneinandergrenzende offene Nuten ineinander übergehen.

Bei dem Außenteil 105 ist für jede Litze eine eigene Einführöffnung vorgesehen, dabei ist nur eine der Einführöffnungen mit dem Bezugszeichen ,110' ausgewiesen. Die jeweilige Einführöffnung 110 ist als Durchgangsbohrung ausgebildet. Einander benachbarte Einführöffnungen sind voneinander getrennt ausgebildet und jeweils durch einen Steg 130 beabstandet.

In der in Fig. 11 dargestellten Einführstellung ist vorgesehen, dass eine jede der Einführöffnungen 109 des gemeinsamen Innenteils 106 mit einer jeweils zugeordneten Einführöffnung 110 des gemeinsamen Außenteils 105 zur Einführung der jeweiligen Litze ausgerichtet ist.

Die Kabel mit den freigelegten Litzen an den jeweiligen abgemantelten Kabelenden werden parallel zueinander ausgerichtet durch einen Greifarm eines Roboters gegriffen und gleichzeitig durch die Einführöffnungen 109 des Innenteils 106 sowie die dazu ausgerichteten Einführöffnungen 110 des Außenteils 105 eingeführt.

Fig. 13 zeigt das zu Fig. 11 beschriebene Ausführungsbeispiel aus einer Blickrichtung. Es ist erkennbar, dass im Bereich der gemeinsamen Aufnahme 107 des Innenteils 106 je eine Rippe zwischen zwei benachbarten Litzen angeordnet ist; dabei ist nur eine der drei Rippen zwischen den insgesamt vier Litzen mit dem Bezugszeichen ,140' ausgewiesen. Die jeweilige Rippe 140 ist an dem Außenteil 105 ausgebildet und erstreckt sich von der Innenseite der vorderen Wand zu der Innenseite der hinteren Wand, jeweils bezogen auf die Einführrichtung der Litzen. Zwischen je zwei Rippen ist genau eine Litze aufgenommen, insbesondere trennen je zwei Rippen genau eine Kontaktfläche, derart, dass ein Kurzschluss zwischen benachbarten Litzen bzw. zwischen benachbarten Kontaktflächen durch die Rippen unterdrückt wird. Weiter verhindert die jeweilige Rippe 140, dass verflüssigtes Lot nicht auf eine benachbarte Kontaktfläche gelangen kann.

In einer Abwandlung des in Fig. 13 dargestellten Ausführungsbeispiels ist vorgesehen, dass das Innenteil 106 Wandabschnitte aufweist, wobei die Wandabschnitte in Bezug auf die Rippen 140 des gemeinsamen Außenteils 105 so ausgebildet sind, dass die Wandabschnitte mit den Rippen jeweils eine annähernd durchgehende Trennwand ausbilden, derart, dass je eine Trennwand zwischen zwei benachbarten Kontaktflächen bzw. zwischen zwei benachbarten Litzen ausgebildet wird.

Bei dem mit Bezug auf Fig. 11 und Fig. 13 beschriebenen Ausführungsbeispiel war vorgesehen, dass ein gemeinsames Innenteil 106 für sämtliche Litzen vorgesehen ist. Durch die Verschiebung des gemeinsamen Innenteils 106 in Bezug auf das gemeinsame Außenteil 105 lassen sich sämtliche Litzen gleichzeitig fixieren. In einer Abwandlung des mit Bezug auf Fig. 11 und Fig. 13 beschriebenen Ausführungsbeispiels ist vorgesehen, dass innerhalb der gemeinsamen Aufnahme 107 des gemeinsamen Außenteils 105 mehrere Innenteile jeweils verschiebbar geführt aufgenommen sind, insbesondere kann für jede der Litzen jeweils genau ein Innenteil vorgesehen sein, dessen jeweilige Verschiebung und Befestigung an dem gemeinsamen Außenteil 105 genau diese Litze auf der dieser Litze zugeordneten Kontaktfläche ermöglicht. Insbesondere kann es in bestimmten Montagesituationen von Vorteil sein, nicht alle Litzen gleichzeitig, sondern nacheinander zu fixieren.

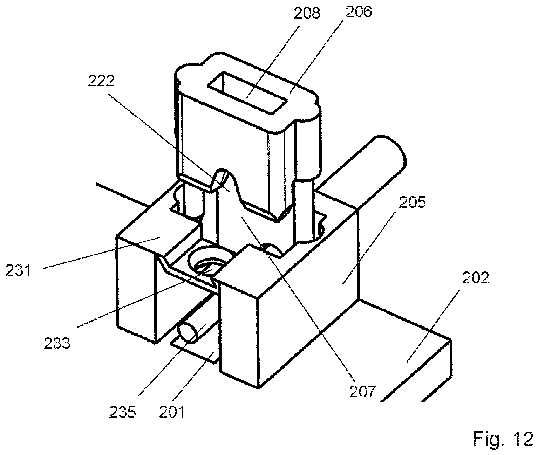

Fig. 12 zeigt ein zweites, zu dem in Fig. 1 bis Fig. 10 beschriebenen Ausführungsbeispiel alternatives Ausführungsbeispiel einer Löthilfe. Abweichend von dem vorstehend beschriebenen Ausführungsbeispiel ist zusätzlich zu dem Zugang in dem Innenteil, das innerhalb einer Aufnahme des Außenteils verschiebbar angeordnet ist, in dem Außenteil eine zusätzliche Zugangsöffnung vorgesehen, die einen weiteren Zugriff auf die auf der Kontaktfläche fixierte Litze ermöglicht, um durch die zusätzliche Zugangsöffnung beispielsweise thermische Energie insbesondere an das freie Ende der Litze zuzuführen, oder beispielsweise das freie Ende der Litze mechanisch fixieren zu können.

Für die Löthilfe ist hierzu vorgesehen, dass ein Innenteil 206 in Richtung der Erstreckung der Litze verkürzt ausgebildet ist und verschiebbar innerhalb einer entsprechend verkürzt bemessenen Aufnahme 207 eines Außenteils 205 aufgenommen ist, wobei mindestens eine Seitenwand des Außenteils 205, nämlich die der Einführöffnung der Litze gegenüberliegende Seitenwand 231 des Außenteils 205, mit vergrößerter Wandstärke ausgebildet ist. Aufgrund der vergrößerten Wandstärke ist es möglich, in diesem Bereich eine zusätzliche Zugangsöffnung 233 vorzusehen, die sich im Wesentlichen parallel zu der verkürzt bemessenen Aufnahme 207 erstreckt und parallel sowie unabhängig von dem in Erstreckungsrichtung der Litze verkürzt ausgelegten Zugang 208 des Innenteils 206 einen weiteren Zugriff auf die Litze ermöglicht. Insbesondere ist es möglich, dass das Innenteil 206 eine Zusatz-Einführöffnung 222 aufweist, die einen zwischen dem freien Ende 235 der Litze und einem in der Einführöffnung des Innenteils 206 eingespannten kantennahen Abschnitt der Litze angeordneten Zwischenabschnitt der Litze aufnimmt und gegen die Kontaktfläche 201 der Leiterplatte 202 verspannt. Das freie Ende 235 der Litze ist dann durch die zusätzliche Zugangsöffnung 233 für die weitere Bearbeitung zugänglich.

### BEZUGSZEICHENLISTE

- 1: Kontaktfläche
- 2: Leiterplatte
- 3: Aufnahmebohrung
- 4: Aufnahmebohrung
- 5: Außenteil
- 6: Innenteil
- 7: Aufnahme
- 8: Zugang
- 9: Einführöffnung des Innenteils 6
- 10: Einführöffnung des Außenteils 5
- 11: Spreizelement
- 12: Spreizlasche
- 13: Hinterschneidung
- 14: Innenseite des Außenteils 5
- 15: Spreizspalt
- 16: Führungsnut
- 17: Absatz
- 18: Außenseite des Innenteils 6
- 19: zylindrischer Abschnitt
- 20: Spreizstift
- 21: Noppen
- 22: Zusatz-Einführöffnung
- 23: Rastvorsprung
- 24: vorfixierte Baueinheit
- 25: Litze
- 26: Mantelkante
- 27: gebogener Abschnitt der Litze 25

- 102: gemeinsame Leiterplatte
- 105: gemeinsames Außenteil
- 106: gemeinsames Innenteil
- 107: gemeinsame Aufnahme
- 108: gemeinsamer Zugang
- 109: Einführöffnung in dem gemeinsamen Innenteil 106
- 110: Einführöffnung in dem gemeinsamen Außenteil 105
- 111: Spreizelement an dem gemeinsamen Außenteil 105
- 112: Spreizlasche
- 130: Steg
- 140: Rippe

- 205: Außenteil
- 206: Innenteil
- 207: Aufnahme
- 208: Zugang
- 222: Zusatz-Einführöffnung
- 231: Seitenwand der Aufnahme
- 233: zusätzliche Zugangsöffnung
- 235: freies Ende der Litze

## Patentansprüche

1. Löthilfe zum Fixieren einer Litze (25) eines Kabels auf einer elektrischen Kontaktfläche (1) einer Leiterplatte (2; 102; 202), umfassend ein Außenteil (5; 105; 205) mit einer Auflagefläche sowie ein Innenteil (6; 106; 206),
wobei das Innenteil (6; 106) innerhalb einer Aufnahme (7; 107; 207) des Außenteils (5; 105; 205) verschiebbar aufgenommen ist,
wobei das Innenteil (6; 106; 206) einen Zugang (8; 108; 208) zu der Kontaktfläche (1; 201) aufweist und in einer Montagestellung an dem Außenteil (5; 105; 205) befestigbar ist, und
wobei in einer Einführstellung eine Einführöffnung (9; 109) des Innenteils (6; 106; 206) mit einer Einführöffnung (10; 110) des Außenteils (5; 105; 205) zur Einführung der Litze (25) des Kabels ausgerichtet ist.

2. Löthilfe nach Anspruch 1, wobei das Innenteil (6; 106; 206) an einer Außenseite (18) abschnittsweise mit einem Abschnitt der Innenseite der Aufnahme (7; 107; 207) des Außenteils (5; 105; 205) ein Führungsflächenpaar ausbildet.

3. Löthilfe nach Anspruch 2, wobei der das Führungsflächenpaar ausbildende Abschnitt (19) der Außenseite (18) des Innenteils (6; 106; 206) im Wesentlichen zylindrisch ausgebildet ist.

4. Löthilfe nach einem der Ansprüche 1 bis 3, wobei das Innenteil (6; 106; 206) an dem Außenteil (5; 105; 205) in der Montagestellung mittels einer Rastverbindung befestigbar ist.

5. Löthilfe nach Anspruch 4, wobei an der Außenseite des Innenteils (6) ein Rastvorsprung (23) ausgebildet ist, der mit einer Hinterschneidung (13) an der Innenseite (14) des Außenteils (5) die Rastverbindung ausbildet.

6. Löthilfe nach einem der Ansprüche 1 bis 5, wobei an dem Außenteil (5) und / oder an dem Innenteil (6) ein Befestigungsmittel für die Festlegung der Löthilfe an der Leiterplatte (2) vorgesehen ist.

7. Löthilfe nach Anspruch 6, wobei das Befestigungsmittel durch die Verschiebung des Innenteils (6) in die Montagestellung betätigbar ist.

8. Löthilfe nach Anspruch 6 oder 7, wobei das Befestigungsmittel an dem Außenteil (5) als Spreizelement (11; 111) mit zwei oder mehr Spreizlaschen (12; 112) unter Ausbildung eines Spreizspaltes (15) ausgebildet ist, und wobei an dem Innenteil (6) ein Spreizstift ausgebildet ist, der, in der Montagestellung, den Spreizspalt (15) derart ausfüllt, dass die Spreizlaschen (12) gegen die Leiterplatte (2) verspannbar sind.

9. Löthilfe nach einem der Ansprüche 1 bis 8, wobei das Innenteil (6) in Bezug auf das Außenteil (5) in eine Fixierstellung verschiebbar ist, und wobei in der Fixierstellung das Innenteil (6) und das Außenteil (5) eine vorfixierte Baueinheit (24) ausbilden.

10. Löthilfe nach einem der Ansprüche 1 bis 9, wobei an der Außenseite (18) des Innenteils (6) ein Fixierabschnitt ausgebildet ist, und wobei an der Innenseite (14) des Außenteils (5) ein zu dem Fixierabschnitt im Wesentlichen komplementärer Aufnahmeabschnitt ausgebildet ist, und wobei in einer Fixierstellung der Fixierabschnitt im Wesentlichen formschlüssig in dem Aufnahmeabschnitt aufgenommen ist.

11. Löthilfe nach Anspruch 10, wobei der Fixierabschnitt als Noppen (21) und der Aufnahmeabschnitt als Vertiefung mit einer zu dem Noppen (21) komplementären Form ausgebildet sind.

12. Löthilfe nach einem der Ansprüche 1 bis 11, wobei die Einführöffnung (9; 109) des Innenteils (6; 106) als in Richtung der Verschiebung offene Nut ausgebildet ist.

13. Löthilfe nach einem der Ansprüche 1 bis 12, wobei die Einführöffnung (10; 110) des Außenteils (5; 105) als Durchgangsbohrung ausgebildet ist.

14. Löthilfe nach einem der Ansprüche 1 bis 13, wobei in der Montagestellung die Einführöffnung (9) des Innenteils (6) versetzt in Bezug auf die Einführöffnung (10) des Außenteils (5) angeordnet ist.

15. Löthilfe nach einem der Ansprüche 1 bis 14, wobei der Einführöffnung (9) des Innenteils (6; 106) in Richtung der Erstreckung der Litze gegenüberliegend eine Zusatz-Einführöffnung (22; 222) vorgesehen ist.

16. Löthilfe nach einem der Ansprüche 1 bis 15, wobei das Innenteil (6) und / oder das Außenteil (5) als einstückiges Formteil aus einem Metall oder einem Kunststoff, insbesondere als Kunststoff-Spritzgussteil ausgebildet ist.

17. Löthilfe nach einem der Ansprüche 1 bis 16, wobei in der Montagestellung das Innenteil (6) vollständig innerhalb der Aufnahme (7) des Außenteils (5) aufgenommen ist.

18. Baugruppe, umfassend eine Leiterplatte (2; 102; 202) und eine Litze (25) eines Kabels, wobei die Litze (25) mittels einer Löthilfe auf einer Kontaktfläche (1; 101; 201) der Leiterplatte (2; 102; 202) befestigt ist, und wobei die Löthilfe nach einem der Ansprüche 1 bis 17 ausgebildet ist.

19. Verfahren zum Fixieren einer Litze eines Kabels auf einer elektrischen Kontaktfläche einer Leiterplatte, mit den Schritten
- Bereitstellen einer Löthilfe mit einem Außenteil (5) und einem innerhalb einer Aufnahme (7) des Außenteils (5) verschiebbar aufgenommenen Innenteil (6),
- Einführen der Litze des Kabels in einer Einführstellung, bei der eine Einführöffnung (9) des Innenteils (6) mit einer Einführöffnung (10) des Außenteils (5) zur Einführung der Litze des Kabels ausgerichtet ist, und
- Verbringen des Innenteils (6) innerhalb der Aufnahme (7) des Außenteils (5) in eine Montagestellung, in der das Innenteil (6) an dem Außenteil (5) befestigt ist, wobei in der Montagestellung ein Durchgang (8) des Innenteils (6) die elektrische Kontaktfläche (1) der Leiterplatte (2) zugänglich lässt, und wobei in der Montagestellung das Außenteil (5) an der Leiterplatte (2) befestigt wird, um die Litze auf der Kontaktfläche zu fixieren.

20. Verfahren nach Anspruch 19, wobei die Löthilfe in einer Fixierstellung, in der das Innenteil (6) und das Außenteil (5) eine vorfixierte Baueinheit (24) ausbilden, bereitgestellt und vor dem Einführen der Litze die vorfixierte Baueinheit (24) auf der Leiterplatte (2) angeordnet wird.
